## Europäisches Patentamt

## European Patent Office

## Office européen des brevets

(19)

(11) Veröffentlichungsnummer: **0 017 099**
**B1**

(12) **EUROPÄISCHE PATENTSCHRIFT**

(45) Veröffentlichungstag der Patentschrift:
**20.07.83**

(21) Anmeldenummer: **80101480.4**

(22) Anmeldetag: **20.03.80**

(51) Int. Cl.³: **H 01 F 35/00,** H 03 B 19/03

(54) **Ruhender magnetischer Frequenzvervielfacher.**

(30) Priorität: **04.04.79 DE 2913612**
**03.03.80 DE 3008125**

(43) Veröffentlichungstag der Anmeldung:
**15.10.80 Patentblatt 80/21**

(45) Bekanntmachung des Hinweises auf die Patenterteilung:
**20.07.83 Patentblatt 83/29**

(84) Benannte Vertragsstaaten:
**AT CH DE FR GB IT NL SE**

(56) Entgegenhaltungen:
**CH-A-377 441**
**DE-B-1 231 804**
**DE-C-305 944**
**GB-A-630 289**
**GB-A-1 051 442**
**US-A-1 559 295**

(73) Patentinhaber: **SIEMENS AKTIENGESELLSCHAFT,**
**Berlin und München Wittelsbacherplatz 2,**
**D-8000 München 2 (DE)**

(72) Erfinder: **Benecke, Wilhelm, Dipl.-Ing., Am**
**Wasserturm 6, D-8740 Neustadt (DE)**
Erfinder: **Rosenberg, Heinz, Dipl.-Ing., Ölzeltgasse 15,**
**A-1238 Wien (AT)**

ACTORUM AG

## Ruhender magnetischer Frequenzvervielfacher

Die Erfindung bezieht sich auf einen ruhenden magnetischen Frequenzvervielfacher, der einen geschlossenen magnetischen Kreis bildende geblechte Eisenkörper und eine in Nuten verteilte mehrphasige Primärwicklung der Polpaarzahl $p_1$ sowie eine mit dieser magnetisch gekoppelte Sekundärwicklung aufweist, deren Polpaarzahl $p_2$ ein ungeradzahliges Vielfaches der Polpaarzahl $p_1$ der Primärwicklung ist, bei welchem Vervielfacher ferner ein Teilbereich der Eisenkörper durch das von der Primärwicklung bei Speisung mit der primären Nennspannung bei Nennfrequenz erzeugte Magnetfeld gesättigt ist.

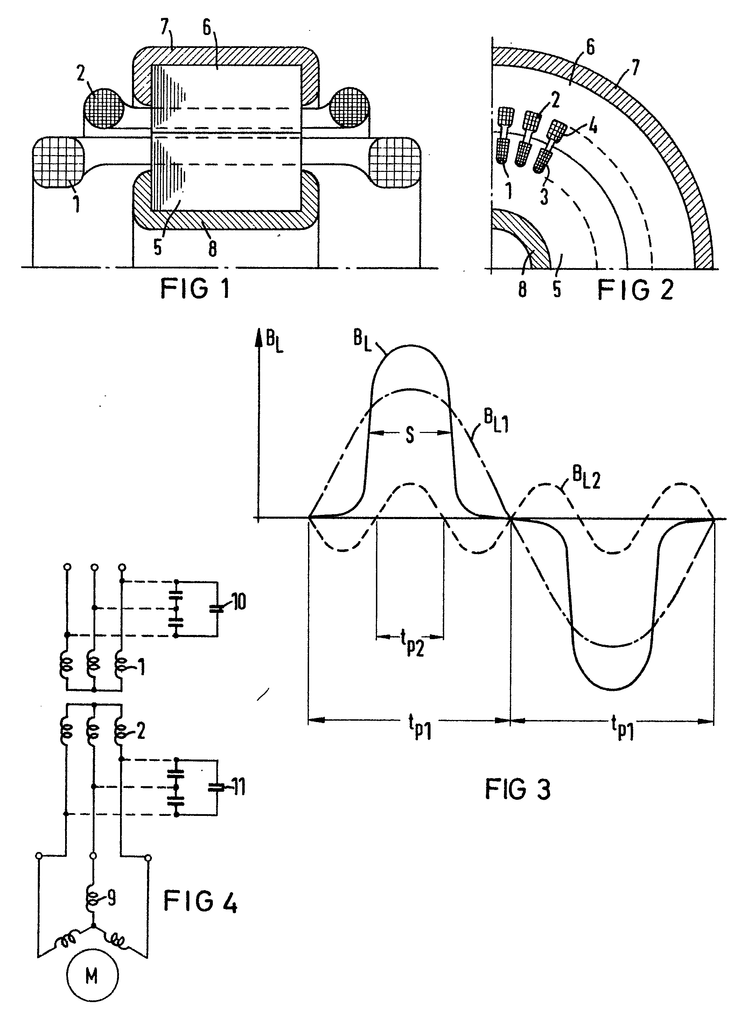

Ein solcher Frequenzvervielfacher ist durch die GB-A-630 289 bekannt. Dieser Frequenzvervielfacher ist so aufgebaut, dass eine Sättigung in der zwischen einem inneren zylindrischen und einem äusseren ringförmigen Rückschlussteil gelegenen Nut-Zahnschicht auftritt. Durch eine solche Sättigung in der Nut-Zahnschicht ergibt sich eine ausgeprägte trapezförmige Verteilung der Flussdichte über der Polteilung, wie dies auch in Fig. 1 dieser Patentschrift dargestellt ist. Eine solche Form der Flussverteilung besteht aus einer Grundharmonischen und deren höheren Harmonischen ungerader Ordnungszahl. Die Amplitude der Harmonischen ist hierbei – unter Voraussetzung einer rechteckförmigen Verteilung der Flussdichte – höchstens ihrer jeweiligen Ordnungszahl umgekehrt proportional. Dies bedeutet ein entsprechend starkes Absinken der Windungsspannungen höherer Frequenz, was letztlich eine geringe Ausnutzung und beträchtliche Wicklungsverluste zur Folge hat. Da bei dem bekannten Frequenzvervielfacher die Sekundärspule jeweils nur einen Zahn umfasst, werden ausser der gewünschten Spannung höherer Frequenz auch noch Spannungen mit anderen Frequenzen induziert. Dies führt zu einem starken Abweichen der Sekundärspannung von der Sinusform.

Der Erfindung liegt die Aufgabe zugrunde, einen Frequenzvervielfacher der eingangs beschriebenen Art so auszubilden, dass er bei höheren Frequenzen wesentlich höhere Windungsspannungen liefert und damit weniger Raum beansprucht, ein geringeres Gewicht aufweist und einen besseren Wirkungsgrad besitzt.

Die Lösung der gestellten Aufgabe gelingt nach der Erfindung dadurch, dass der gesättigte Teilbereich im Rückschlussweg (Joch) vorgesehen ist und die Primär- und Sekundärwicklungen mittels an sich bekannter Massnahmen so ausgebildet sind, dass an den Klemmen der Primärwicklung praktisch nur von der Grundharmonischen eines Feldes der Polpaarzahl $p_1$ eine Spannung und von der gleichen Grundharmonischen sowie den von der Polpaarzahl $p_2$ abweichenden Harmonischen an den Klemmen der Sekundärwicklung keine Spannung induziert werden kann.

Die Erfindung wird nachstehend anhand der Zeichnungen näher erläutert:

Fig. 1 und 2 zeigen ein Ausführungsbeispiel in schematischer Darstellung und

Fig. 3 zeigt die durch magnetische Sättigung im Rückschlussjoch erzielbare räumliche Flussdichte-Verteilung und ihre Zerlegung in Harmonische.

Fig. 4 zeigt ein Beispiel der Schaltung einschliesslich eines angeschlossenen Motors.

Fig. 5 und 6 zeigen Massnahmen zur Dämpfung unerwünschter parasitärer Magnetflüsse.

Fig. 7 stellt ein Ausführungsbeispiel mit Ringwicklung und

Fig. 8 den Zusammenbau mit einem Asynchronmotor dar.

Fig. 9 zeigt die sogenannte rechteckige Hystereseschleife von an sich bekannten Werkstoffen, die aufgrund dieser Schleifenausbildung für eine erfindungsgemässe Anwendung besonders geeignet sind.

Fig. 10 und 11 stellen schematisch ein Ausführungsbeispiel mit Ringwicklung dar, das nach dem Wanderfeldprinzip arbeitet,

Fig. 12 einen nach dem Wanderfeldprinzip arbeitenden Frequenzvervielfacher im Längsschnitt, bei dem die Nuten zur Aufnahme der Primär- und Sekundärwicklung in dem den Rückschluss bildenden Eisenkörper angeordnet sind,

Fig. 13 einen Querschnitt des in Fig. 12 dargestellten Frequenzvervielfachers,

Fig. 14 einen nach dem Wanderfeldprinzip arbeitenden Frequenzvervielfacher im Längsschnitt, bei dem die Nuten in dem von der Primär- und Sekundärwicklung umschlossenen Eisenkörper angeordnet sind,

Fig. 15 und 16 Zahnkopfkonturen, durch die ein gegenüber dem Zahnquerschnitt grösserer Übergangsquerschnitt für den Magnetfluss erreicht wird.

Beim Frequenzvervielfacher nach den Fig. 1 und 2 ist die Primärwicklung 1 in Nuten 3 am Aussenumfang eines zylindrischen Blechpaketes 5 und die Sekundärwicklung 2 in korrespondierenden Nuten 4 am Innenumfang eines hohlzylindrischen Blechpaketes 6 untergebracht. Diese Ausführung ist für die Herstellung der Wicklungen, ferner bei hohen Spannungen sowie zwecks Verbesserung bei Abfuhr der Verlustwärme besonders vorteilhaft. Bei diesem Ausführungsbeispiel ist die magnetische Sättigung erfindungsgemäss in das Joch von mindestens einem der Blechpakete 5 bzw. 6 (in den Fig. 1 und 2 in beide) verlegt. Um den Austritt von die Sättigung vermindernden, also parasitären Streuflüssen entgegenzuwirken, können an den gesättigten Jochen massive Dämpfungskörper 7 und 8 vorgesehen sein, die aus einem amagnetischen Werkstoff guter elektrischer Leitfähigkeit, insbesondere einem Leichtmetall, bestehen.

Die mehrphasige Primärwicklung 1 hat die Polpaarzahl $p_1$ (vorzugsweise $p_1 = 2$ oder 4) und ist erfindungsgemäss mittels an sich bekannter Massnahmen – z.B. Zusammenschaltung der Wicklungsstränge, Sehnung, Strangverschachtelung, Abstufung der Leiterzahlen je Nut, Nutschränkung – so ausgeführt, dass praktisch nur die Grundharmonische eines Drehfeldes der Polpaarzahl $p_1$ eine Spannung an ihren Klemmen induzieren kann (sogenannte oberwellenfreie Wicklung). Unter Voraussetzung einer Sinusform der die Primärwicklung 1 speisenden Netzspannung führt eine solche Wicklung auch bei hoher Eisensättigung nur sinusförmige Magnetisierungsströme, die eine räumlich sinusförmig verteilte Drehdurchflutung erzeugen.

In Fig. 3 ist die ausgeprägt nichtsinusförmige Verteilung der Flussdichte $B_L$ des Drehfeldes über der Polteilung $t_{p1}$ dargestellt, die bei Jochsättigung entsteht. Die Flussdichte $B_L$ ist jeweils über eine Nutteilung gemittelt. Ein solches Drehfeld enthält neben der Grundharmonischen mit der Flussdichte $B_{L_1}$ ausgeprägte höhere Harmonische ungerader Ordnungszahl, von denen hier beispielsweise die dritte Harmonische mit dem Flussdichtenverlauf $B_{L2}$ und der Polteilung $t_{p2} = t_{p1}/3$ eingezeichnet ist. Diese Harmonische weist daher die 3fache Polzahl der Primärwicklung 1 auf ($p_2 =$ 3p1), rotiert jedoch mit der gleichen Geschwindigkeit wie die Grundharmonische. Sie induziert daher in der ein- oder mehrphasigen Sekundärwicklung 2, die erfindungsgemäss die Polpaarzahl $p_2$ aufweist, die 3fache Primärfrequenz. Die Sekundärwicklung 2 ist so gestaltet, dass sie von der Grundharmonischen der Polpaarzahl $p_1$ nicht induziert werden kann – bei den meisten üblichen Wicklungen ist dies von vornherein der Fall –, dass vorteilhafterweise aber auch die anderen Harmonischen des gesättigten Drehfeldes (Polpaarzahlen $p \neq p_2$) ihre Klemmenspannung praktisch nicht beeinflussen können. Dies ist mit den im Zusammenhang mit der Primärwicklung erwähnten bekannten Massnahmen erreichbar. Die Ausführung mit Jochsättigung hat den Vorteil, dass mit dem Jochquerschnitt die Breite S (Fig. 3) des steilflankigen Drehfeldteiles im Verhältnis zur Polteilung $t_{p1}$ der Primärwicklung 1 variiert und damit der Anteil der Oberwelle gewünschter Ordnung optimiert werden kann.

Erfindungsgemäss können auch andere Harmonische des Drehfeldes als in Fig. 3 dargestellt – z.B. die fünfte oder siebente – zu einer ihrer Ordnungszahl entsprechenden Frequenzvervielfachung herangezogen werden.

In Fig. 4 ist ein Schaltungsbeispiel dargestellt. Die dreiphasige Primärwicklung 1 ist zweckmässig im Stern geschaltet, da kann in ihren Strängen Spannungsoberschwingungen, deren Ordnungszahl durch drei teilbar ist, induziert werden dürfen, ohne in den Anschlussklemmen aufzutreten. Auch bei der Sekundärwicklung 2 erleichtert die Sternschaltung die Wicklungsauslegung. Die Ständerwicklung 9 eines angeschlossenen Motors kann beliebig geschaltet sein. Um das Netz von der Magnetisierungsblindleistung zu entlasten, die der Primärwicklung 1 zugeführt werden muss, können Kondensatoren 10 zu dieser Wicklung parallelgeschaltet sein. Durch Anschluss von weiteren Kondensatoren 11 an die Sekundärwicklung 2 wird diese vom Motorblindstrom entlastet, was einerseits die Wicklungsverluste vermindert und anderseits eine Spannungsstützung bewirkt.

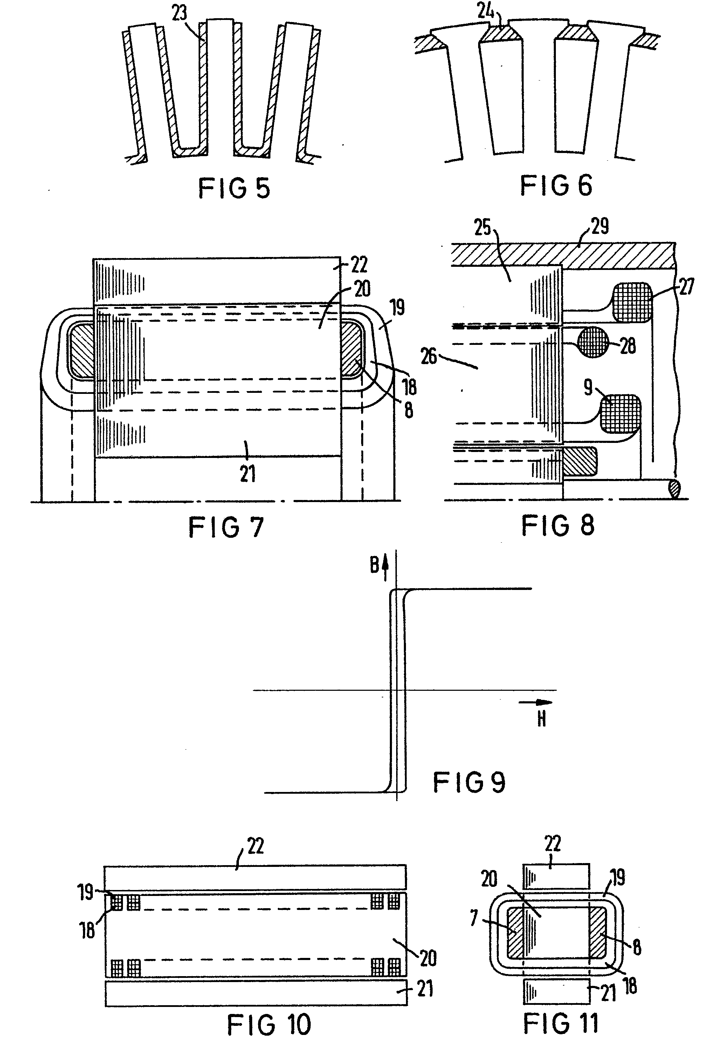

Um Magnetflüsse in den Nuten, die eine Sättigung des Joches vermindern, wegzudämpfen, können gegenüber den Zähnen isolierte Dämpfungseinlagen 23 nach Fig. 5 vorgesehen sein, die aus einem amagnetischen Werkstoff guter elektrischer Leitfähigkeit – vorzugsweise Kupfer oder Aluminium – bestehen.

Die Sättigung eines ungenuteten Blechpaketes kann durch parasitäre Magnetflüsse quer durch Nut und Zahnkopf verringert werden. Um solche Flüsse zu dämpfen, können gegenüber den Zähnen isolierte metallische Nutverschlusskeile 24, wie in Fig. 6 dargestellt, vorgesehen sein.

Ein Ausführungsbeispiel der Erfindung, bei dem eine beträchtliche Wickelkopfausladung einer niederpoligen Primärwicklung vermieden und gleichzeitig eine gute Ausnutzung erzielt wird, ist in Fig. 7 dargestellt. Dort sind eine Primärwicklung 18 und eine Sekundärwicklung 19 als Ringwicklung ausgeführt und auf einem aussen und innen mit gleicher Nutenzahl versehenen ringförmigen Blechpaket 20 angeordnet. An den Stirnseiten dieses Blechpaketes sind zur Dämpfung von Streuflüssen die vorzugsweise aus Leichtmetall bestehenden massiven Dämpfungskörper 7 und 8 vorgesehen. Es entstehen hier zwei Drehfelder, die sich im Joch des Blechpaketes 20 vereinigen und in einem in der Öffnung des ringförmigen Blechpaketes 20 angeordneten inneren Blechpaket 21 bzw. in einem das Blechpaket 20 umschliessenden äusseren Blechpaket 22 ihren Rückschlussweg finden.

Fig. 8 zeigt schematisch eine Vereinigung des Frequenzvervielfachers mit einem von ihm gespeisten Asynchronmotor. Die Blechpakete 25 und 26 mit den Primär- bzw. Sekundärwicklungen 27 und 28 sind im Gehäuse 29 des Motors untergebracht, dessen Ständerwicklung 9 in Nuten des hohlzylindrischen Blechpaketes 26 angeordnet und an die Sekundärwicklung 28 angeschlossen ist.

Bei einer vorteilhaften Variante der Erfindung bestehen die Blechpakete oder zumindest die zur Sättigung vorgesehenen Teile derselben aus einem Werkstoff mit rechteckiger Hystereseschleife gemäss Fig. 9 und die magnetischen Vorzugsrichtungen, denen diese Schleife zugeordnet ist, sind in der Sättigungszone zumindest näherungsweise in die Richtung des magnetischen Kraftlinienverlaufes verlegt. Da die völlige Sättigung derartiger Werkstoffe bereits bei sehr geringer Feldstärke eintritt, ergibt sich einerseits eine sehr kleine primäre Blindleistung des Frequenzvervielfachers und damit eine Einsparung an Wicklungsverlusten und leichte Entbehrlichkeit von primärseitig angeschlossenen Kondensatoren (10 in Fig. 4), anderseits können Massnahmen zur Dämpfung von sättigungsvermindernden parasitären Magnetflüssen entfallen.

Bei den in den Fig. 1, 2, 7 und 8 dargestellten Ausführungsbeispielen, die durch zylindrische geblechte Eisenkörper mit Drehfeldern gekennzeichnet sind, müssen für die Anwendbarkeit von Blechen mit Rechteckschleife die Eisenkörper aus Blechsegmenten, vorzugsweise mit Stossstellenüberlappung, aufgebaut sein – wie es bei grossen elektrischen Maschinen üblich ist –, um in den einzelnen Segmenten die Kraftlinienrichtung in den Zähnen bzw. im Joch – z.B. nur angenähert – der magnetischen Vorzugsrichtung zuzuordnen. Dieser Aufwand kann durch die Ausführung nach den Fig. 10 und 11 vermieden werden. Das gesättigte Feld ist hier ein Wanderfeld, das von der primären Ringwicklung 18, die zusammen mit der sekundären Ringwicklung 19 in den beidseitigen Nutungen des Blechpaketes 20 untergebracht ist, erregt wird. Die Blechpakete 21 und 22 sind als Rückschlussteile vorgesehen, die Dämpfungskörper 7 und 8 unterdrücken stirnseitig aus dem Paket austretende Streuflüsse. Die Anordnung nach den Fig. 10 und 11 bildet gewissermassen ein über ein oder mehrere Polpaare der Primärwicklung reichendes und geradegebogenes Segment der Anordnung nach Fig. 7. Die Wanderfeldausführung nach den Fig. 10 und 11 zeichnet sich durch Kompaktheit, minimalen Blechverschnitt bei der Fertigung und problemlose Einhaltung der Fugen zwischen den Blechpaketen aus. Wenn für das Blechpaket 20 Blech mit rechteckiger Hystereseschleife nach Fig. 9 verwendet und die Vorzugsrichtung in die Achse der zu sättigenden Zähne verlegt wird, sind die geschilderten Vorteile dieses Werkstoffes ohne Einbusse erzielbar.

Bei der in den Fig. 10 und 11 dargestellten Wanderfeldausführung wurde davon ausgegangen, dass sich die genutete Zone des betreffenden Eisenkörpers über ein geradzahliges Vielfaches der Polteilung der Primärwicklung erstreckt, da nur dann die algebraische Summe aller Zahnflüsse dauernd gleich Null und somit ausser den Zähnen kein weiterer Flusspfad zwischen den mit den Wicklungen versehenen Eisenkörpern und den den Rückschluss bildenden Eisenkörpern erforderlich ist. Mit Rücksicht auf eine praktische Oberwellenfreiheit der Primär- und Sekundärwicklung ist eine nicht zu kleine Nutenzahl je Pol und Strang vorteilhaft. Hierbei sind desto mehr Nuten erforderlich, je höher die sekundäre Frequenz und damit die Polzahl der Sekundärwicklung ist. Die Nuten und Zähne können aus technologischen Gründen nicht beliebig schmal bemessen werden. Die für zwei volle primäre Polteilungen erforderliche Nutenzahl kann daher zu einer solchen Länge der genuteten Zone des Eisenkörpers führen, dass insbesondere bei kleineren Leistungen des Frequenzvervielfachers die Abmessungen bzw. Proportionen des Eisenkörpers ungünstig werden.

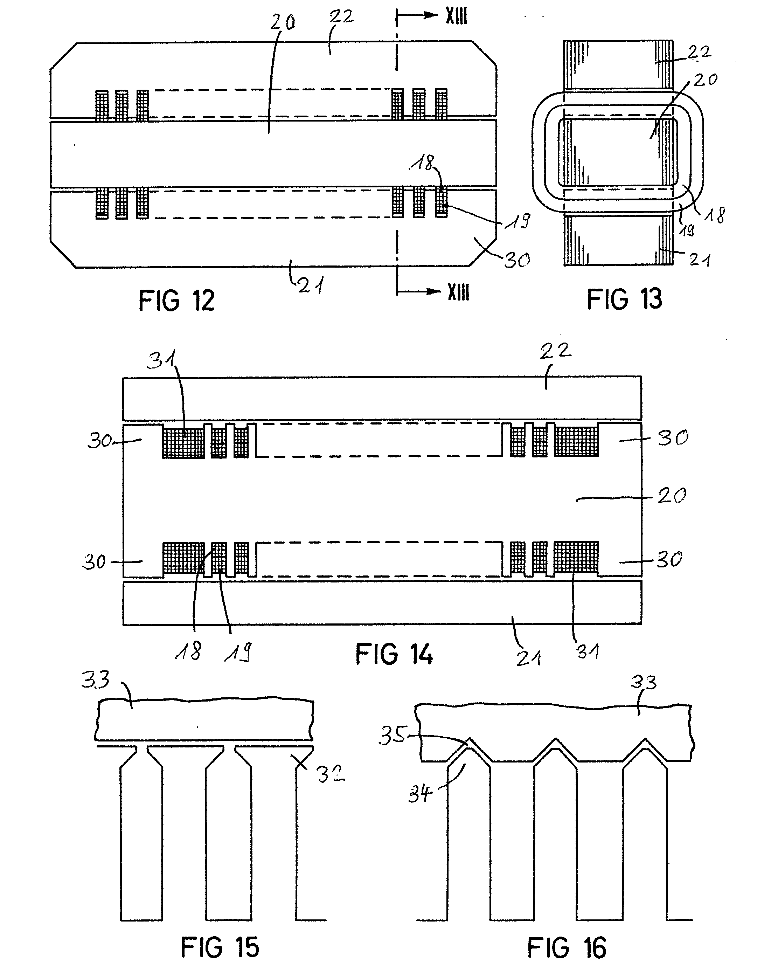

Bei den in den Fig. 12 und 14 dargestellten Frequenzvervielfachern erstreckt sich die den Eisenkörper 20 zusammen mit der Sekundärwicklung 19 umfassende mehrphasige Primärwicklung 18 über weniger als zwei ganze primäre Polteilungen. Für die Unterbringung der Primär- und Sekundärwicklung sind daher weniger Nuten erforderlich als bei einer Ausführung, bei der sich die mehrphasige Primärwicklung jeweils über mindestens zwei ganze Polteilungen erstreckt. Ein solcher Frequenzvervielfacher kann jeweils mit geeigneten konstruktiven Abmessungen ausgeführt werden, da wegen der geringeren Nutenzahl die Baulänge des Eisenkörpers verkürzt ist. Da sich die mehrphasige Primärwicklung 18 über weniger als zwei ganze Polteilungen erstreckt, ist die Summe aller Zahnflüsse jedoch nicht mehr dauernd Null, sondern es tritt ein magnetischer Wechselfluss auf, der durch geblechte Verbindungsteile 30, die ausserhalb der bewickelten Zone angeordnet sind, zu den den Rückschluss bildenden Eisenkörpern 21 und 22 geführt wird. Die magnetischen Verbindungsteile 30 sind so bemessen, dass sie in allen vorgesehenen Betriebszuständen ungesättigt bleiben, um die Wirkungsweise der funktionsgemäss gesättigten Bereiche im Rückschlussweg nicht störend zu beeinflussen.

Da sich zumindest die Primärwicklung 18 nicht über ein ganzes Polteilungspaar bzw. ein ganzzahliges Vielfaches davon erstreckt, ist ebenso wie die Summe aller Zahnflüsse die Summe aller Durchflutungen nicht dauernd Null. Bei der in Fig. 12 dargestellten Ausführungsform des Frequenzvervielfachers, bei der eine Sättigung im Rückschlussweg (Joch) bei ungesättigten Zähnen vorliegt, hat dies keine Bedeutung, da alle Durchflutungen bereits durch die Sättigung im Rückschlussweg aufgehoben werden, so dass die magnetischen Verbindungsteile 30 ebenso wie die Zähne, zu denen sie einen magnetischen Nebenschluss bilden, ohne besondere Massnahmen ungesättigt bleiben. Wäre hingegen bei der Ausführungsform nach Fig. 12 Zahnsättigung bei ungesättigtem Rückschlussweg vorgesehen, so würde die jeweilige Durchflutungssumme der Wicklungen einen zusätzlichen (parasitären) magnetischen Wechselfluss durch den aus den Eisenkörpern 21, 22 und 20 sowie den magnetischen Verbindungsteilen 30 bestehenden magnetischen Kreis treiben, der diese Teile funktionsstörend sättigen und unerwünschte induktive Spannungsabfälle in den Wicklungen induzieren würde. Um dies zu vermeiden, sind bei der in Fig. 14 dargestellten Ausführungsform für Zahnsättigung zwischen den Wänden der genuteten Zone und den magnetischen Verbindungsteilen 30 Kompensationswicklungen 31 angeordnet. Diese sind so ausgelegt und mit der Primär- bzw. Sekundärwicklung 18 bzw. 19 in Reihe geschaltet, dass sie die von diesen Wicklungen erzeugte Wechseldurchflutung aufheben.

Es kann vorteilhaft sein, die Primärwicklung 18 über ein ganzes Polteilungspaar oder ein ganzzahliges Vielfaches davon zu erstrecken, um z.B. für alle Stränge hinsichtlich der Belastung und der Spannungsabfälle Symmetrie zu erzielen. Dies wird dadurch erreicht, dass der Frequenzvervielfacher aus zwei oder mehr getrennt angeordneten Eisenkörpern 20 mit zwischen diesen und deren zugehörigen Rückschlusskörpern 21 und 22 angeordneten Verbindungsteilen 30 besteht, wobei die in den Nuten der Eisenkörper 20 bzw. 21 und 22 angeordneten Primärwicklungen 18 in Reihe geschaltet und so ausgelegt sind, dass sie zusammen ein geradzahliges Vielfaches einer Polteilung umfassen.

Die zur Aufnahme der als Ringwicklungen ausgebildeten Primär- und Sekundärwicklungen 18 und 19 bestimmten Nuten können wahlweise in dem Eisenkörper 20 (Fig. 14) oder in den den Rückschluss bildenden Eisenkörpern 21 und 22 (Fig. 12 und 13) vorgesehen werden. Im erstgenannten Fall wird in die Nuten hineingewickelt, was für den Wärmeaustausch zwischen Wicklung und Eisen günstig ist. Im andern Fall können die einzelnen Spulen der Wicklung vorgefertigt und über den Eisenkörper 20 geschoben und danach die den Rückschluss bildenden Eisenkörper 21 und 22 darübergestülpt werden, was bei höherer Spannung isolationstechnisch vorteilhaft ist.

Die magnetischen Verbindungsteile 30 können als Fortsetzung des Eisenkörpers 20 (Fig. 14) oder der den Rückschluss bildenden Eisenkörper 21, 22 (Fig. 12) ausgebildet sein, wobei die betreffenden Eisenkörper vorzugsweise auch die Nuten für die Wicklungen aufweisen.

Wenn für die jeweils mit Nuten versehenen Eisenkörper 20 bzw. 21 und 22 ein Werkstoff mit höherer Sättigungsflussdichte vorgesehen ist, als sie der Werkstoff der ungenuteten Eisenkörper aufweist, so wird zur Vermeidung störender magnetischer Engpässe vorgeschlagen, die Kontur der Zahnköpfe 32 und 34 so auszubilden, dass der Übergangsquerschnitt für den Magnetfluss von einem Zahnkopf 32 bzw. 34 zum benachbarten, den Rückschluss bildenden Eisenkörper 33 grösser als der Zahnquerschnitt ist. Gemäss Fig. 15 ist dies durch die an sich bekannte Ausbildung der Zähne 32 bei halbgeschlossenen Nuten erreicht. Sind dagegen aus wicklungstechnischen Gründen offene Nuten erforderlich, so können die Zähne 34, wie in Fig. 16 dargestellt, dachförmig abgeschrägt werden, wobei die Zähne 34 mit ihrer Abschrägung in entsprechende Vertiefungen 35 des den Rückschluss bildenden Eisenkörpers 33 hineinragen.

**Patentansprüche**

1. Ruhender magnetischer Frequenzvervielfacher, der einen geschlossenen magnetischen Kreis bildende geblechte Eisenkörper (5, 6) und eine in Nuten (3) verteilte mehrphasige Primärwicklung (1) der Polpaarzahl $p_1$ sowie eine mit dieser magnetisch gekoppelte Sekundärwicklung (2) aufweist, deren Polpaarzahl $p_2$ ein ungeradzahliges Vielfaches der Polpaarzahl $p_1$ der Primärwicklung (1) ist, bei welchem Vervielfacher ferner ein Teilbereich der Eisenkörper (5, 6) durch das von der Primärwicklung bei Speisung mit der primären Nennspannung bei Nennfrequenz erzeugte Magnetfeld gesättigt ist, dadurch gekennzeichnet, dass der gesättigte Teilbereich im Rückschlussweg (Joch) vorgesehen ist und die Primär- und Sekundärwicklungen (1 und 2) mittels an sich bekannter Massnahmen so ausgebildet sind, dass an den Klemmen der Primärwicklung (1) praktisch nur von der Grundharmonischen eines Feldes der Polpaarzahl $p_1$ eine Spannung und von der gleichen Grundharmonischen sowie den von der Polpaarzahl $p_2$ abweichenden Harmonischen an den Klemmen der Sekundärwicklung (2) keine Spannung induziert werden kann.

2. Frequenzvervielfacher nach Anspruch 1, dadurch gekennzeichnet, dass die Primärwicklung (1) und die Sekundärwicklung (2) in je einem genuteten zylindrisch bzw. hohlzylindrisch ausgebildeten Blechpaket (5 bzw. 6) angeordnet und die Blechpakete (5 und 6) ineinandersteckbar sind (Fig. 1, 2).

3. Frequenzvervielfacher nach Anspruch 1, dadurch gekennzeichnet, dass die Primärwicklung (18) und die Sekundärwicklung (19) als Ringwicklungen ausgebildet und auf einem beidseitig genuteten geblechten Eisenkörper (20) angeordnet sind und der magnetische Rückschluss durch zu beiden Seiten des Eisenkörpers (20) vorgesehene geblechte Eisenkörper (21 und 22) bewirkt ist (Fig. 7, 10, 11).

4. Frequenzvervielfacher nach einem der vorhergehenden Ansprüche, dadurch gekennzeichnet, dass mindestens im Bereich der magnetisch gesättigten Teile der Blechpakete (5, 6 bzw. 20) Dämpfungskörper (7, 8) aus einem amagnetischen Werkstoff guter elektrischer Leitfähigkeit angeordnet sind.

5. Frequenzvervielfacher nach Anspruch 4, dadurch gekennzeichnet, dass die Dämpfungskörper (7, 8) seitlich neben dem gesättigten Rückschluss angeordnet sind.

6. Frequenzvervielfacher nach Anspruch 4, dadurch gekennzeichnet, dass die Dämpfungskörper in Form einer Nuteinlage (23) ausgebildet und gegenüber den Zähnen isoliert in den Nuten angeordnet sind (Fig. 5).

7. Frequenzvervielfacher nach Anspruch 4, dadurch gekennzeichnet, dass die Dämpfungskörper als Nutverschlusskeile (24) ausgebildet und gegenüber den Zähnen isoliert in den Nutöffnungen angeordnet sind (Fig. 6).

8. Frequenzvervielfacher nach einem der vorhergehenden Ansprüche, dadurch gekennzeichnet, dass die geblechten Eisenkörper (25 und 26) mit der Primär- bzw. Sekundärwicklung (27 bzw. 28) im Gehäuse (29) eines Motors untergebracht sind und die Ständerwicklung (9) dieses Motors in Nuten des hohlzylindrischen Eisenkörpers (26) angeordnet und an die Sekundärwicklung (28) angeschlossen ist (Fig. 8).

9. Frequenzvervielfacher nach einem der vorhergehenden Ansprüche, dadurch gekennzeichnet, dass zumindest der magnetisch gesättigte Teil der Eisenkörper aus einem Werkstoff mit rechteckiger Hystereseschleife besteht und die magnetischen Vorzugsrichtungen, denen diese Schleife zugeordnet ist, wenigstens in der Sättigungszone zumindest näherungsweise mit der Richtung der magnetischen Kraftlinien übereinstimmen (Fig. 8).

10. Frequenzvervielfacher nach einem der vorhergehenden Ansprüche, dadurch gekennzeichnet, dass an die Primärwicklung (1) und/oder Sekundärwicklung (2) Kondensatoren (10 bzw. 11) angeschlossen sind (Fig. 4).

11. Frequenzvervielfacher nach den Ansprüchen 3 und 9, dadurch gekennzeichnet, dass die Blechpakete (20 bis 24) rechteckig ausgebildet sind.

12. Frequenzvervielfacher nach den Ansprüchen 1 und 3, dadurch gekennzeichnet, dass ausserhalb der bewickelten Zone geblechte Eisenkörper vorgesehen sind, die ungesättigt bleibende magnetische Verbindungsteile (30) zwischen dem von den Wicklungen (18, 19) umfassten Eisenkörpern (20) und den Rückschlussteilen (21, 22) bilden.

13. Frequenzvervielfacher nach Anspruch 12, dadurch gekennzeichnet, dass zwei oder mehr genutete Eisenkörper mit zwischen diesen und deren zugehörigen Rückschlusskörpern angeordneten Verbindungsteilen (30) getrennt angeordnet sind, wobei deren in Serie geschalteten Primärwicklungen (18) zusammen ein geradzahliges Vielfaches einer Polteilung umfassen.

14. Frequenzvervielfacher nach Anspruch 13, dadurch gekennzeichnet, dass jeweils die genuteten Eisenkörper (21, 22 bzw. 20), deren Primärwicklung (18) kein geradzahliges Vielfaches einer Polteilung umfasst, Kompensationswicklungen (31) aufweisen, die zwischen den Enden der genuteten Zone und den magnetischen Verbindungsteilen (30) angeordnet sind.

15. Frequenzvervielfacher nach einem der Ansprüche 12, 13 oder 14, dadurch gekennzeichnet, dass die die Primär- und Sekundärwicklung (18 und 19) aufnehmenden Nuten in den den Rückschluss bildenden Eisenkörpern (21 und 22) vorgesehen sind (Fig. 12).

16. Frequenzvervielfacher nach einem der Ansprüche 12, 13 oder 14, dadurch gekennzeichnet, dass die die Primär- und Sekundärwicklung (18 und 19) aufnehmenden Nuten in dem von den Wicklungen umschlossenen Eisenkörper (20) vorgesehen sind (Fig. 14).

17. Frequenzvervielfacher nach einem der Ansprüche 12 bis 16, dadurch gekennzeichnet, dass die magnetischen Verbindungsteile (30) als Fortsetzungen zumindest eines der Eisenkörper (21, 22 bzw. 20) des magnetischen Kreises ausgebildet sind.

18. Frequenzvervielfacher nach Anspruch 17, dadurch gekennzeichnet, dass die magnetischen Verbindungsteile (30) als Fortsetzungen des jeweils mit Nuten versehenen Eisenkörpers (21, 22 bzw. 20) ausgebildet sind.

19. Frequenzvervielfacher nach einem der Ansprüche 12 bis 18, dadurch gekennzeichnet, dass die Kontur mindestens eines Teiles der Zahnköpfe (32, 34) so ausgebildet ist, dass der Übergangsquerschnitt für den Magnetfluss von einem Zahnkopf (32 bzw. 34) zum benachbarten Eisenkörper (33) grösser als der Zahnquerschnitt ist.

## Claims

1. A static magnetic frequency multiplier which comprises metal plated iron bodies ( 5, 6 ) forming a closed magnetic circuit, a multi-phase primary winding (1) distributed in grooves (3) and possessing a number of pole pairs $p_1$, and a secondary winding (2) magnetically coupled to the first and having a number of pole pairs $p_2$ equal to an odd numbered multiple of the number of pole pairs $p_1$ of the primary winding (1), in which multiplier a sub-zone of the iron bodies (5, 6) is saturated by the magnetic field generated by the primary winding when a primary nominal voltage at the nominal frequency is applied, characterised in that the saturated sub-zone is arranged in the return path (yoke), and the primary and secondary windings (1 and 2) are formed by measures known per se in such manner that an operative voltage can only be induced across the terminals of the primary winding (1) by the fundamental harmonics of a field having the number of pole pairs $p_1$, whereas no effective voltage is induced across the terminals of the secondary winding (2) by the same fundamental harmonics and by the harmonics which deviate from the number of pole pairs $p_2$.

2. A frequency multiplier as claimed in Claim 1, characterised in that the primary winding (1) and the secondary winding (2) are arranged each in a grooved, cylindrical or hollow-cylindrical stack of metal sheets (5 and 6), and the stacks of the metal sheets (5 and 6) inserted into one another (Figs. 1, 2).

3. A frequency multiplier as claimed in Claim 1, characterised in that the primary winding (18) and the secondary winding (19) consist of annular windings and are arranged on a metal plated iron body (20) grooved on both sides, and the magnetic return path is produced by metal plated iron bodies (21 and 22) arranged on both sides of the iron body (20) (Figs. 7, 10, 11).

4. A frequency multiplier as claimed in one of the preceding Claims, characterised in that at least in the region of the magnetically saturated components of the stacks of metal sheets (5, 6 and 20), attenuating bodies (7, 8) are arranged of an amagnetic material of good electrical conductivity.

5. A frequency multiplier as claimed in Claim 4, characterised in that the attenuating bodies (7, 8) are arranged laterally beside the saturated return path.

6. A frequency multiplier as claimed in Claim 4, characterised in that the attenuating bodies are in the form of a groove insert (23) and arranged in the grooves so as to be insulated from the teeth (Fig. 5).

7. A frequency multiplier as claimed in Claim 4, characterised in that the attenuating bodies are formed by grooved sliding wedge-type breech blocks (24) are arranged in the groove openings so as to be insulated from the teeth (Fig. 6).

8. A frequency multiplier as claimed in one of the preceding Claims, characterised in that the metal plated iron bodies (25 and 26) are accommodated together with the primary and secondary windings (27 and 28) in the housing (29) of a motor, and the stator winding (9) of this motor is arranged in grooves in the hollow cylindrical iron body (26) and is connected to the secondary winding (28) (Fig. 8).

9. A frequency multiplier as claimed in one of the preceding Claims, characterised in that at least the magnetically saturated part of the iron bodies consists of a material which possesses a rectangular hysteresis loop, and the magnetic preferred directions assigned this loop conform, at least in the saturation zone, at least approximately with the direction of the magnetic flux lines (Fig. 8).

10. A frequency multiplier as claimed in one of the preceding Claims, characterised in that capacitors (10 and 11) are connected to the primary winding (1) and/or the secondary winding (2) (Fig. 4).

11. A frequency multiplier as claimed in Claims 3 and 9, characterised in that the stacks of metal sheets (20 to 24) are of rectangular formation.

12. A frequency multiplier as claimed in Claims 1 and 3, characterised in that outside of the wound zone there are metal plated iron bodies which form magnetic connecting components (30) that remain unsaturated, between the iron body (20) gripped by the windings (18, 19) and the return path components (21, 22).

13. A frequency multiplier as claimed in Claim 12, characterised in that there are two or more separately arranged grooved iron bodies with connecting components (30) between the latter and their associated returnpath bodies, their primary windings (18) connected in series together comprising an even numbered multiple of a pole pitch.

14. A frequency multiplier as claimed in Claim 13, characterised in that the grooved iron bodies (21, 22 and 20) whose primary winding (18) does not comprise an even numbered multiple of a pole pitch, possess compensation windings (31) arranged between the ends of the grooved zone and the magnetic connecting components (30).

15. A frequency multiplier as claimed in one of the Claims 12, 13 or 14, characterised in that the grooves which accommodate the primary and secondary windings (18 and 19) are arranged in the iron bodies (21 and 22) which form the return path (Fig. 12).

16. A frequency multiplier as claimed in one of the Claims 12, 13 or 14, characterised in that the grooves which accommodate the primary and secondary windings (18 and 19) are arranged in the iron body (20) which is enclosed by the windings (Fig. 14).

17. A frequency multiplier as claimed in one of the Claims 12 to 16, characterised in that the magnetic connecting components (30) represent continuation of at least one of the iron bodies (21, 22 and 20) of the magnetic circuit.

18. A frequency multiplier as claimed in Claim 17, characterised in that the magnetic connecting components (30) represent continuations of the iron body (21, 22 and 20) which is provided with grooves.

19. A frequency multiplier as claimed in one of the Claims 12 to 18, characterised in that the contour of at least one part of the tooth heads (32, 34) is such that the transition cross-section for the magnetic flux from a tooth head (32, 34) to the adjacent iron body (33) is greater than the cross-section of the tooth.

**Revendications**

1. Multiplicateur de fréquence magnétique statique qui comporte un corps en fer feuilleté (5, 6) formant un circuit magnétique fermé, et un enroulement primaire polyphasé (1) réparti dans des encoches (3) et possédant un nombre $p_1$ de paires de pôles ainsi qu'un enroulement secondaire (2) qui y est couplé magnétiquement et dont le nombre $p_2$ de paires de pôles est un multiple impair du nombre $p_1$ de paires de pôles de l'enroulement primaire, multiplicateur dans lequel en outre une région partielle du corps en fer (5, 6) est saturée par le champ magnétique produit à la fréquence nominale par l'enroulement primaire lorsqu'il est alimenté par la tension nominale primaire, caractérisé par le fait que la région partielle saturée est prévue dans le retour (culasse) et les enroulements primaire et secondaire (1 et 2) sont agencés, au moyen de mesures connues en soi, de manière qu'une tension ne puisse être induite aux bornes de l'enroulement primaire (1) que pratiquement par l'harmonique fondamentale d'un champ du nombre $p_1$ de paires de pôles, et qu'aucune tension ne puisse être induite aux bornes de l'enroulement secondaire (2) par la même harmonique fondamentale ni par les harmoniques différant du nombre $p_2$ de paires de pôles.

2. Multiplicateur de fréquence suivant la revendication 1, caractérisé par le fait que l'enroulement primaire (1) et l'enroulement secondaire (2) sont respectivement disposés dans un paquet de tôles présentant une forme cylindrique comportant des encoches ou une forme cylindrique creuse (5 ou 6), et que les paquets de tôles (5 et 6) peuvent être montés l'un dans l'autre (figs 1, 2).

3. Multiplicateur de fréquence suivant la revendication 1, caractérisé par le fait que l'enroulement primaire (18) et l'enroulement secondaire (19) se présentent sous la forme d'enroulements annulaires, et sont disposés sur un corps en fer feuilleté (20) muni d'encoches des deux côtés, et que le retour magnétique s'effectue à travers des corps en fer feuilletés (21 et 22) prévus des deux côtés du corps en fer (20) (figs 7, 10, 11).

4. Multiplicateur de fréquence suivant l'une des revendications précédentes, caractérisé par le fait que des corps d'affaiblissement (7, 8), constitués par un matériau non magnétique présentant une bonne conductivité électrique, sont disposés au moins dans la région des parties des paquets de tôles (5, 6 ou 20) qui sont saturées magnétiquement.

5. Multiplicateur de fréquence suivant la revendication 4, caractérisé par le fait que les corps d'affaiblissement (7, 8) sont disposés latéralement à côté du retour saturé.

6. Multiplicateur de fréquence suivant la revendication 4, caractérisé par le fait que les corps d'affaiblissement se présentent sous la forme d'une garniture (23) des encoches, et sont disposés dans les encoches de façon isolée, en face des dents (fig. 5).

7. Multiplicateur de fréquence suivant la revendication 4, caractérisé par le fait que les corps d'affaiblissement se présentent sous la forme de cales d'encoche (24) et sont disposés de façon isolée dans les ouvertures des encoches, en face des dents (fig. 6).

8. Multiplicateur de fréquence suivant l'une des revendications précédentes, caractérisé par le fait que les corps en fer feuilletés (25 et 26), avec l'enroulement primaire ou secondaire (27 ou 28), sont logés dans le carter (29) d'un moteur, et que l'enroulement statorique (9) de ce moteur est disposé dans des encoches du corps en fer cylindrique creux (26) et est raccordé à l'enroulement secondaire (28) (fig.8).

9. Multiplicateur de fréquence suivant l'une des revendications précédentes, caractérisé par le fait qu'au moins la partie du corps en fer qui est saturée magnétiquement est constituée par un matériau présentant une boucle d'hystétésis rectangulaire, et que les directions magnétiques préférentielles auxquelles est associée cette boucle coïncident au moins approximativement avec la direction des lignes de champ magnétiques, au moins dans la zone de saturation (fig. 8).

10. Multiplicateur de fréquence suivant l'une des revendications précédentes, caractérisé par le fait que des condensateurs (10 ou 11) sont raccordés à l'enroulement primaire (1) et/ou à l'enroulement secondaire (2) (fig. 4).

11. Multiplicateur de fréquence suivant les revendications 3 et 9, caractérisé par le fait que les paquets de tôles (20 à 24) possèdent une forme rectangulaire.

12. Multiplicateur de fréquence suivant les revendications 1 et 3, caractérisé par le fait qu'à l'extérieur de la zone munie d'enroulements sont prévus des corps en fer feuilletés, qui forment des parties de couplage magnétiques (30) restant non saturées, entre le corps en fer (20) entouré par les enroulements (18, 19) et les parties de retour (21, 22).

13. Multiplicateur de fréquence suivant la revendication 12, caractérisé par le fait que deux corps en fer munis d'encoches, ou plus, avec des parties de couplage (30) disposées entre ces corps en fer et leurs corps de retours associés, sont disposés de façon séparée, leurs enroulements primaires (18) montés en série entourant conjointement un multiple pair d'un pas polaire.

14. Multiplicateur de fréquence suivant la revendication 13, caractérisé par le fait que les corps en fer munis d'encoches (21, 22 ou 20), dont l'enroulement primaire (18) n'entoure pas un multiple pair d'un pas polaire, comportent des enroulements de compensation (31) qui sont disposés entre les extrémités de la zone munie d'encoches et les pièces de couplage magnétiques (30).

15. Multiplicateur de fréquence suivant l'une des revendications 12, 13 ou 14, caractérisé par le fait que les encoches recevant les enroulements primaire et secondaire (18 et 19) sont prévues dans les corps en fer (21 et 22) formant le retour (fig. 12).

16. Multiplicateur de fréquence suivant l'une des revendications 12, 13 ou 14, caractérisé par le fait que les encoches recevant les enroulements primaire et secondaire (18 et 19) sont prévues dans le corps en fer (20) entouré par les enroulements (fig. 14).

17. Multiplicateur de fréquence suivant l'une des revendications 12 à 16, caractérisé par le fait que les pièces de couplage magnétiques (30) se présentent sous la forme de prolongements d'au moins un des corps en fer (21, 22 ou 20) du circuit magnétique.

18. Multiplicateur de fréquence suivant la revendication 17, caractérisé par le fait que les pièces de couplage magnétiques (30) se présentent sous la forme de prolongements du corps en fer (21, 22 ou 20) respectivement munis d'encoches.

19. Multiplicateur de fréquence suivant l'une des revendications 12 à 18, caractérisé par le fait que le contour d'au moins une partie des têtes des dents (32, 34) est agencé de manière que la section transversale de passage pour le flux magnétique d'une tête de dent (32 ou 34) vers le corps en fer voisin (33) soit plus importante que la section transversale de la dent.

FIG 1

FIG 2

FIG 3

FIG 4

FIG 5

FIG 6

FIG 7

FIG 8

FIG 9

FIG 10

FIG 11

FIG 12

FIG 13

FIG 14

FIG 15

FIG 16